# EUROPEAN PATENT SPECIFICATION

(11) **EP 1 072 087 B1**
(45) Date of publication and mention of the grant of the patent: **03.09.2003**
(21) Application number: 99920688.1
(22) Date of filing: 15.04.1999
(51) Int. Cl.: H03B 5/12

(54) **VOLTAGE CONTROLLED OSCILLATOR**
SPANNUNGSGESTEUERTER OSZILLATOR
OSCILLATEUR A COMMANDE EN TENSION

(30) Priority: 15.04.1998 GB 9808041
(43) Date of publication of application: 31.01.2001
(73) Proprietor: MOTOROLA GmbH, 65232 Taunusstein (DE)
(72) Inventor: LICHTERFELD, Stefan, D-65232 Taunusstein (DE)
(74) Representative: Treleven, Colin
(86) International application number: EP9902579
(87) International publication number: WO99053608

(56) References cited:
- DE-A- 3 246 295
- DE-A- 3 842 859
- US-A- 4 621 241
- US-A- 4 785 263
- US-A- 5 144 264

## Description

### Technical Field

The invention concerns a voltage controlled oscillator.

### Background

A voltage controlled oscillator (VCO) is designed to produce an output signal of a particular frequency. This frequency is determined by the level of a voltage which is input to the oscillator. The output frequency of the oscillator can be varied by varying the magnitude of the voltage which is input to the oscillator. Typically, a voltage controlled oscillator may be used to provide a signal for transmission by the transmitter of a communications system.

The output frequency of the VCO can be varied reliably between a certain maximum frequency and a certain minimum frequency. The frequencies between these limits are referred to as the VCO's frequency range. A wide-band VCO needs to cover a frequency range of at least 25% of the centre value of the frequency range. There are however particular requirements for phase noise performance and transmitter modulation linearity over this frequency range. These requirements usually result in the VCO being a complicated circuit.

In some applications, such as for example in portable radios, VCOs have to be of small size. Small-sized designs of VCO tend to have a low component count. This reduces the allowed complexity. Small-sized designs also require smaller components. This means, for example, that resonator coils which can be used only have a limited, low Q factor.

A VCO of small size therefore has fewer, smaller components. This makes it difficult to meet the requirements for phase noise performance and transmitter modulation linearity over the frequency range of operation of the VCO.

There is a need to find a simple circuit that allows a good compromise between VCO performance and limited space.

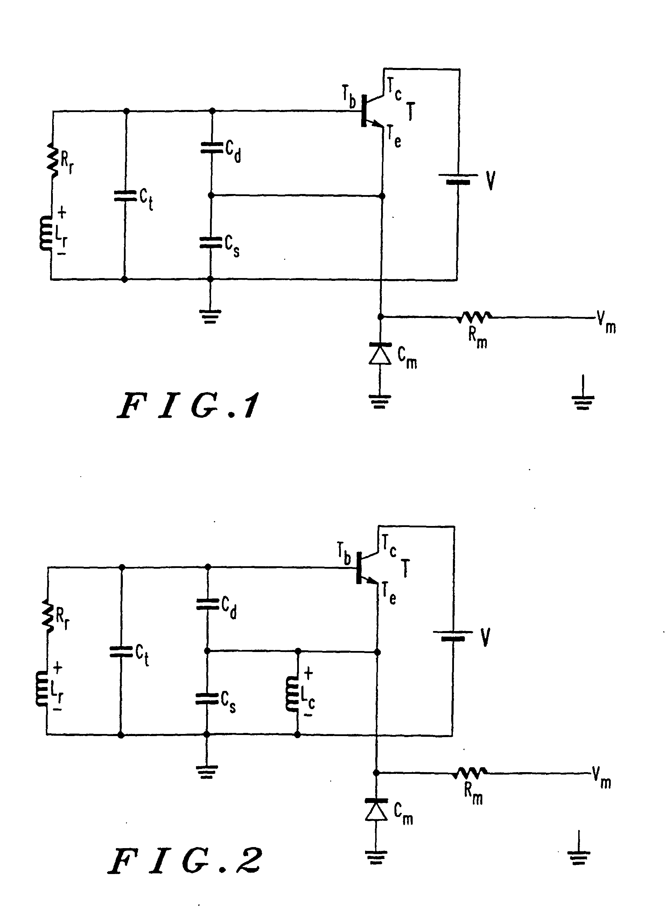

One known design of VCO is called a 'Colpitts Oscillator'. Figure 1 shows an example of a Colpitts oscillator.

The main features of the Colpitts oscillator design are illustrated in figure 1. There is a transistor T, which has two capacitors Cd and Cs connected in series between its base and ground. The mid-point of the two capacitors is connected to the emitter of the transistor. A voltage source V is connected between the collector of the transistor and earth.

A tuning capacitor Ct is connected in parallel to the capacitors Cd and Cs. Ct is preferably a varactor which can be tuned to the desired capacitance value by applying a tuning voltage. A real circuit including de-coupling capacitors and resistors is not shown in figure 1 in order to keep the figure clear. Ct may however be any other tuneable capacitor. Also connected in parallel to both capacitor Ct and capacitors Cd and Cs is an inductor Lr. The values of the inductor Lr and capacitor Ct together determine the resonant frequency of the VCO. Clearly, this resonant frequency varies as the value of Ct is varied.

A resistor Rr has been shown in series with inductor Lr. Resistor Rr symbolises the losses in the coil Lr. These lossy effects are important, and are a major problem which is solved by the applicant's invention. The value of these losses in a real circuit depends on how much the inductor Lr differs from being a perfect inductance, and these losses are frequency dependent.

Finally, a varactor Cm and resistor Rm are provided, and are supplied with a modulation voltage Vm. This is the usual arrangement for providing frequency modulation, the voltage Vm providing frequency modulation of the VCO's output.

The Colpitts oscillator design of figure 1 suffers from two significant drawbacks:
(i) A Colpitts oscillator may be designed for best noise performance over a narrow frequency range. However, the design aim of having smaller components leads to difficulties. With smaller components, the Q factors which are achievable decrease. This decreases the useable bandwidth as a result of damping effects by the coil losses which are symbolised on figure 1 as Rr.
   At oscillator frequencies at the lower end of the oscillator's range, the increased resonator circuit losses Rr require a higher feedback gain to provide the same output signal level. However, the amount of this feedback gain must be decreased at higher frequencies because the currents in the tank coils and the losses have reduced damping effect at higher frequencies.
(ii) The FM modulation provided by the varactor circuit Cm varies with frequency. At low oscillator frequencies the large tuning varactor's capacity Ct loads the modulation varactor Cm and therefore decreases the modulation deviation. The modulation deviation increases with rising oscillator frequencies due to smaller tuning varactor capacitance Ct while Cm stays constant.

The disadvantages of the circuit arrangement of figure 1 make it clear that the arrangement of figure 1 is not suited to the aim of size minimisation.

Published US patent US-A-4785263 shows a known oscillator. The oscillator can be constructed as a voltage controlled oscillator. The oscillator has a pair of capacitors connected in series between the gate of a FET and ground. The junction of these capacitors is connected to the source of the FET by the parallel connection of a resistor and a third capacitor 31. A choke is connected between the junction of the pair of serially connected capacitors and ground, in order to provide a DC supply path to the source of the FET.

US patent US-A-5 144 264 shows a Colpitts oscillator having a series LC circuit in the feedback circuit in order to frequency compensate the oscillator.

### Summary of the Invention

A voltage-controlled oscillator in accordance with the invention comprises: a transistor, which has base, emitter and collector terminals; a parallel tuned circuit connected between the base terminal of the transistor and ground; a pair of capacitors connected in series between the base terminal of the transistor and ground, the junction between the pair of series connected capacitors being connected to the emitter terminal of the transistor; means for varying the ratio of the effective impedances of the pair of series connected capacitors with frequency, so as to counteract the effects on the output signal of the oscillator arising from losses in the parallel tuned circuit, the means for varying the ratio of the effective impedances comprising a second inductor connected in parallel to the one of said series connected capacitors that is connected to ground; and wherein the values of the capacitor connected to ground and second inductor are chosen such that the effective shunt impedance to ground that they provide increases with decreasing VCO frequency in a similar manner to the way that the damping factor of the parallel tuned circuit increases.

The parallel tuned circuit may comprise a first inductor and a tuneable capacitor arranged in parallel. The second inductor and the series connected capacitor to which it is connected in parallel may have values which are such that their resonant frequency as a parallel circuit combination is about half of the VCO's center frequency, and their effective impedance at the VCO's center frequency is about equal to the value which an optimised pure shunt capacitance would have in the same location. The voltage-controlled oscillator may further comprise means for injecting a modulation signal into the junction between the pair of series connected capacitors in order to provide frequency modulation of the output signal of the voltage controlled oscillator.

### Brief description of the drawings

Figure 1 shows one form of voltage controlled oscillator of the prior art.
Figure 2 shows a voltage controlled oscillator in accordance with the invention.

### Detailed description of the preferred embodiment

The present invention can compensate for the disadvantages outlined above in connection with the circuit arrangement of figure 1.

In its broadest form, the invention concerns the provision of compensation in a voltage controlled oscillator. The compensation provided is such as to counteract the undesirable effects with varying frequency of coil losses. The compensation provided in accordance with the invention provides a suitable VCO output signal over a wider output frequency range than is obtainable with the arrangement of figure 1.

A circuit in accordance with the present invention is shown in figure 2. Elements in figure 2 which correspond to those in figure 1 are labelled with the same reference signs. The arrangement of figure 2 includes an inductor Lc, which provides compensation. The interaction of inductor Lc with the remainder of the circuit elements shown in figure 2 will be clear from the explanation which follows.

In the circuit arrangement of figure 2, the VCO frequency is basically set by the resonance frequency of Lr and Ct.

A coil Lc of suitable inductance value has been added to the circuit in parallel to capacitor Cs of the capacitive shunt path Cd - Cs of the feedback voltage divider. Cs and Lc are chosen in such a way that the effective shunt impedance to ground which they provide increases with decreasing VCO frequency, in a similar manner to the way that the damping factor Rr of the lossy resonator increases. Preferably, the effective shunt impedance to ground of the combination of Cs and Lc increases with decreasing VCO frequency exactly as much as the damping factor Rr of the lossy resonator increases. This arrangement achieves substantial compensation of the losses due to Lr.

With only a pure capacitive voltage divider in the circuit, formed by Cd- Cs, a constant divider ratio would be set. This might take a value of e. g. 1/ 4. However, with the interacting combination of a suitable Cs and Lc design as shown in figure 2, the divider ratio is not fixed. This ratio will vary with frequency. It may range, for example, from about 1/3 at the lower end to about 1/5 at the upper end. The resonant frequency of the parallel circuit combination of Lc and Cs is designed to be about half of the VCO's center frequency. The effective impedance of the combination of Lc and Cs equals the value of the optimised capacitance of a pure shunt capacitance at the VCO's center frequency. This means that at the VCO's centre frequency, the combination of circuit elements Lc and Cs in the arrangement of figure 2 provides an equivalent impedance to that of the pure capacitance Cs in figure 1.

Without Lc the capacitive feedback divider ratio Cd/Cs would stay constant over frequency without gain compensation. However, with Lc, the ratio Cd/(Cs in parallel to Lc) will vary in proportion to the VCO's frequency. This allows an optimised feedback ratio to be set over a wider compensated frequency range. Additionally, a wider range of optimisable phase-noise performance is achieved.

A modulation voltage Vm can be coupled via resistor Rm to the modulation varactor Cm which is connected in parallel to the shunt circuit consisting of Cs in parallel with Lc. The frequency modulation deviation is dependent on the modulation voltage and on the varying shunt impedance. The varying shunt impedance will increase at lower oscillator frequencies, as explained above. This results in a linearised modulation deviation over the full tracking range.

The voltage controlled oscillator circuit of the invention can be designed to operate over a frequency range of, for example, 130 MHz- 180 MHz. Over this range, the VCO's output has a good phase-noise characteristic. This is the case even when coils are employed in the design which have a low quality factor.

The correct values of Cs and Lc can be calculated with suitable simulation tools, for maximum precision. These tools are available to the person skilled in the art and are not explained in detail here.

A voltage controlled oscillator in accordance with the invention can be used in a portable radio such as a PMR radio. This design of voltage controlled oscillator requires less space than prior art VCO circuits. A voltage controlled oscillator in accordance with the invention requires only components of lower precision than do prior art designs. This makes the design cheaper, and saves on VCO trimming. A voltage-controlled oscillator in accordance with the invention can also be used in a mobile radio or a mobile telephone.

## Claims

1. A voltage-controlled oscillator comprising:
a transistor (T), having base (Tb), emitter (Te) and collector (Tc) terminals;
a parallel tuned circuit (Lr, Ct) connected between the base (Tb) terminal of the transistor and ground;
a pair of capacitors (Cd, Cs) connected in series between the base (Tb) terminal of the transistor (T) and ground, the junction between the pair of series connected capacitors (Cd, Cs) being connected to the emitter (Te) terminal of the transistor (T);
means for varying the ratio of the effective impedances of the pair of series connected capacitors (Cd, Cs) with frequency, so as to counteract the effects on the output signal of the oscillator arising from losses in the parallel tuned circuit (Lr, Ct), the means for varying the ratio of the effective impedances comprising a second inductor (Lc) connected in parallel to the said series connected capacitor (Cs), which is connected to ground; and
wherein the values of capacitor (Cs) and second inductor (Lc) are chosen such that the effective shunt impedance to ground that they provide increases with decreasing VCO frequency in a similar manner to the way that the damping factor (Rr) of the parallel tuned circuit (Lr, Ct) increases.

2. The voltage-controlled oscillator of claim 1, wherein the parallel tuned circuit comprises a first inductor (Lr) and a tuneable capacitor (Ct) arranged in parallel.

3. The voltage-controlled oscillator of claim 1 or claim 2, wherein the said second inductor (Lc) and the said series connected capacitor (Cs) to which it is connected in parallel have values which are such that their resonant frequency as a parallel circuit combination is about half of the VCO's center frequency, and their effective impedance at the VCO's center frequency is about equal to the value which an optimised pure shunt capacitance would have in the same location.

4. The voltage-controlled oscillator of any previous claim comprising means (Cm, Rm, Vm) for injecting a modulation signal into the junction between the pair of series connected capacitors (Cd, Cs) in order to provide frequency modulation of the output signal of the voltage controlled oscillator.

5. A portable or mobile radio or a mobile telephone comprising a voltage-controlled oscillator in accordance with any previous claim.

## Patentansprüche

1. Spannungsgesteuerter Oszillator, der folgendes umfasst:
einen Transistor (T), der Basis(Tb)-, Emitter(Te)- und Kollektor(Tc)-Anschlüsse hat;
eine abgestimmte Parallelschaltung (Lr, Ct), die zwischen den Basis(Tb)-Anschluss des Transistors und Masse geschaltet ist;
ein Kondensatorpaar (Cd, Cs), das zwischen den Basis(Tb)-Anschluss des Transistors (T) und Masse in Reihe geschaltet ist, wobei die Verbindung zwischen den in Reihe geschalteten Kondensatoren (Cd, Cs) mit dem Emitter(Te)-Anschluss des Transistors (T) verbunden ist;
Mittel zum Variieren des Verhältnisses der effektiven Impedanzen des in Reihe geschalteten Kondensatorpaares (Cd, Cs) mit der Frequenz, um so den Effekten auf das Ausgangssignal des Oszillators entgegenzuwirken, die aus Verlusten in der abgestimmten Parallelschaltung (Lr, Ct) entstehen, wobei die Mittel zum Variieren des Verhältnisses der effektiven Impedanzen einen zweiten Induktor (Lc) umfassen, der parallel zu dem in Reihe geschalteten Kondensator (Cs) geschaltet ist, der mit Masse verbunden ist; und
bei dem die Werte des Kondensators (Cs) und des zweiten Induktors (Lc) so gewählt werden, dass die effektive Shuntimpedanz zur Masse, die sie zur Verfügung stellen, mit abnehmender VCO-Frequenz auf ähnliche Weise ansteigt, wie der Dämpfungsfaktor (Rr) der abgestimmten Parallelschaltung (Lr, Ct) ansteigt.

2. Spannungsgesteuerter Oszillator gemäß Anspruch 1, bei dem die abgestimmte Parallelschaltung einen ersten Induktor (Lr) und einen abstimmbaren Kondensator (Ct) umfasst, die parallel angeordnet sind.

3. Spannungsgesteuerter Oszillator gemäß Anspruch 1 oder Anspruch 2, bei denen der zweite Induktor (Lc) und der in Reihe geschaltete Kondensator (Cs), mit dem er parallel geschaltet ist, Werte haben, die so sind, dass ihre Resonanzfrequenz als eine Parallelschaltungskombination ungefähr die Hälfte der Mittenfrequenz des VCO beträgt, und ihre effektive Impedanz bei der Mittenfrequenz des VCO ungefähr gleich dem Wert ist, den eine optimierte reine Shuntkapazität am selben Ort hätte.

4. Spannungsgesteuerter Oszillator nach einem der vorhergehenden Ansprüche, der Mittel (Cm, Rm, Vm) zum Einspeisen eines Modulationssignals in die Verbindung zwischen dem in Reihe geschalteten Kondensatorpaar (Cd, Cs) umfasst, um die Frequenzmodulation des Ausgangssignals des spannungsgesteuerten Oszillators zur Verfügung zu stellen.

5. Tragbare oder mobile Funkeinrichtung oder Mobiltelefon, die einen spannungsgesteuerten Oszillator gemäß einem der vorhergehenden Ansprüche umfassen.

## Revendications

1. Oscillateur commandé en tension comprenant :
un transistor (T) qui comporte des bornes de base (Tb), d'émetteur (Te) et de collecteur (Tc) ;
un circuit accordé parallèle (Lr, Ct) qui est connecté entre la borne de base (Tb) du transistor et la masse ;
deux condensateurs (Cd, Cs) qui sont connectés en série entre la borne de base (Tb) du transistor (T) et la masse, la jonction entre les deux condensateurs connectés en série (Cd, Cs) étant connectée à la borne d'émetteur (Te) du transistor (T) ;
un moyen pour faire varier le rapport des impédances efficaces des deux condensateurs connectés en série (Cd, Cs) en fonction de la fréquence de manière à contrer les effets sur le signal de sortie de l'oscillateur résultant de pertes dans le circuit accordé parallèle (Lr, Ct), le moyen pour faire varier le rapport des impédances efficaces comprenant un second inducteur (Lc) qui est connecté en parallèle audit condensateur connecté en série (Cs), lequel second inducteur est connecté à la masse,
dans lequel les valeurs du condensateur (Cs) et du second inducteur (Lc) sont choisies de telle sorte que l'impédance de shunt efficace sur la masse qu'ils assurent augmente lorsque la fréquence du VCO diminue d'une façon similaire à la façon selon laquelle le facteur d'amortissement (Rr) du circuit accordé parallèle (Lr, Ct) augmente.

2. Oscillateur commandé en tension selon la revendication 1, dans lequel le circuit accordé parallèle comprend un premier inducteur (Lr) et un condensateur accordable (Ct) qui sont agencés en parallèle.

3. Oscillateur commandé en tension selon la revendication 1 ou 2, dans lequel ledit second inducteur (Lc) et ledit condensateur connecté en série (Cs) auquel il est connecté en parallèle présentent des valeurs qui sont telles que la fréquence de résonance en tant que combinaison de circuit parallèle est égale à environ la moitié de la fréquence centrale du VCO et leur impédance efficace pour la fréquence centrale du VCO est égale à environ la valeur qu'une capacité de shunt pure optimisée devrait avoir au même endroit.

4. Oscillateur commandé en tension selon l'une quelconque des revendications précédentes, comprenant un moyen (Cm, Rm, Vm) pour injecter un signal de modulation dans la jonction entre les deux condensateurs connectés en série (Cd, Cs) afin d'assurer une modulation en fréquence du signal de sortie de l'oscillateur commandé en tension.

5. Téléphone portable ou radio mobile ou mobile comprenant un oscillateur commandé en tension selon l'une quelconque des revendications précédentes.
